# EUROPEAN PATENT SPECIFICATION

(11) **EP 4 505 531 B1**
(45) Date of publication and mention of the grant of the patent: **21.10.2026**
(21) Application number: 23804466.3
(22) Date of filing: 10.05.2023
(51) Int. Cl.: H10F 19/80, H02J 7/35, H10F 77/42, G08C 17/00

(54) **CONTROLLING DEVICE HAVING AN ENERGY HARVESTING FEATURE**
STEUERUNGSVORRICHTUNG MIT ENERGIEGEWINNUNGSFUNKTION
DISPOSITIF DE COMMANDE COMPRENANT UN ÉLÉMENT DE COLLECTE D'ÉNERGIE

(30) Priority: 12.05.2022 US 202217742483
(43) Date of publication of application: 12.02.2025
(73) Proprietor: Universal Electronics Inc., Scottsdale, AZ 85254 (US)
(72) Inventor: XU, Rex, Scottsdale, AZ 85254 (US); GHARAPETIAN, Ara, Scottsdale, AZ 85254 (US)
(74) Representative: Carpmaels & Ransford LLP
(86) International application number: PCT/US2023/066806
(87) International publication number: WO 2023/220616

(56) References cited:
- CN-Y- 201 207 626
- DE-U1- 202020 104 180
- US-A1- 2012 017 988
- US-A1- 2015 199 062
- US-B2- 8 193 759

## Description

### BACKGROUND

The following relates generally to controlling devices and, more particularly, to a controlling device, such as a hand-held, remote control device, having one or more energy harvesting features.

A remote control with an energy harvesting feature is generally known in the art. For example, U.S. Patent No. 7,605,689 describes a remote control that includes energy harvesting in addition to a battery. The energy harvesting and the battery may be switchably used to power transmit operations, receive operations, and/or display operations. The remote control may be used as part of an automotive vehicle remote keyless entry system in which vehicle status is displayed by the remote control

Similarly, U.S. Patent No. 8,193,759 describes a remote body that includes a light-powered battery and a control panel. The control panel has a plurality of buttons. The light-powered battery module is disposed in the remote and comprises the light panel, the control unit, and the storage unit. The light panel is a rigid or flexible light panel and is used for receiving light energy. The wireless control module disposed in the remote comprises the transmitting unit, the sensing unit, and the activating unit. The light-powered battery module converts and stores the light energy and provides power to the wireless control module, thereby providing energy savings and environmental conservation benefits.

So as to avoid having to repeat the well-known information that is contained within these patents, U.S. Patent Nos. 7,605,689 and 8,193,759.
US 2015/0199062 discloses a wireless input-output device powered by a solar cell.

### SUMMARY

The invention is defined by the independent claim. A selection of optional features of the invention is set out in the dependent claims.

### BRIEF DESCRIPTION OF THE DRAWINGS

For use in better understanding the example controlling devices described hereinafter reference may be had to the following drawings in which:
Figure 1 illustrates an example system in which the example controlling devices may be utilized;
Figure 2 illustrates a block diagram of example components of the example controlling devices;
Figure 3A illustrates an exploded view of an example controlling device, light-based energy harvesting feature;
Figure 3B illustrates the assemblage of the controlling device, light-based energy harvesting feature of Fig. 3A; and
Figure 4 illustrates a portion of a lens usable with the light-based energy harvesting feature of Fig. 3A.

### DETAILED DESCRIPTION

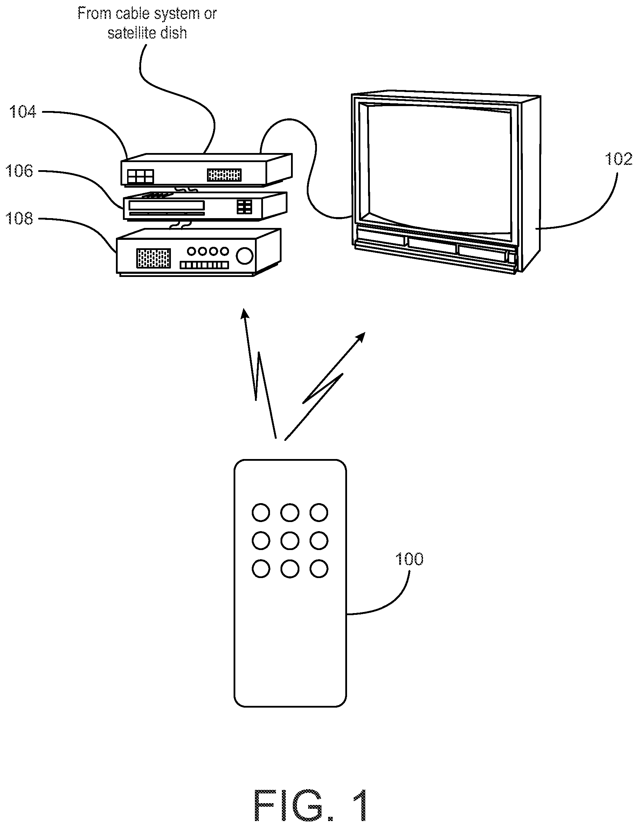

By way of example, Fig. 1 shows an exemplary system, including controllable appliances, such as a set top box ("STB") 104, a VCR 106, an audio amplifier/receiver 108 and a television 102, as well as a controlling device 100. The controlling device 100 includes one or more energy harvesting features as described below and is capable of transmitting commands to the appliances, using any convenient IR, RF, Point-to-Point, or networked protocol, to cause the appliances to perform operational functions, such as to turn on/off, to tune to a media content, to change volume levels, etc. While illustrated in the context of a STB 104 with a VCR 106, audio system 108, and television 102, it is to be understood that controllable appliances can include, but are not limited to, televisions, VCRs, DVRs, DVD players, cable or satellite converter set-top boxes (STBs), amplifiers, CD players, game consoles, home lighting, drapery controls, fans, HVAC systems, thermostats, personal computers, etc. As such, the instant example disclosures are not intended to be limiting as to type or quantity of controllable appliances or equipment.

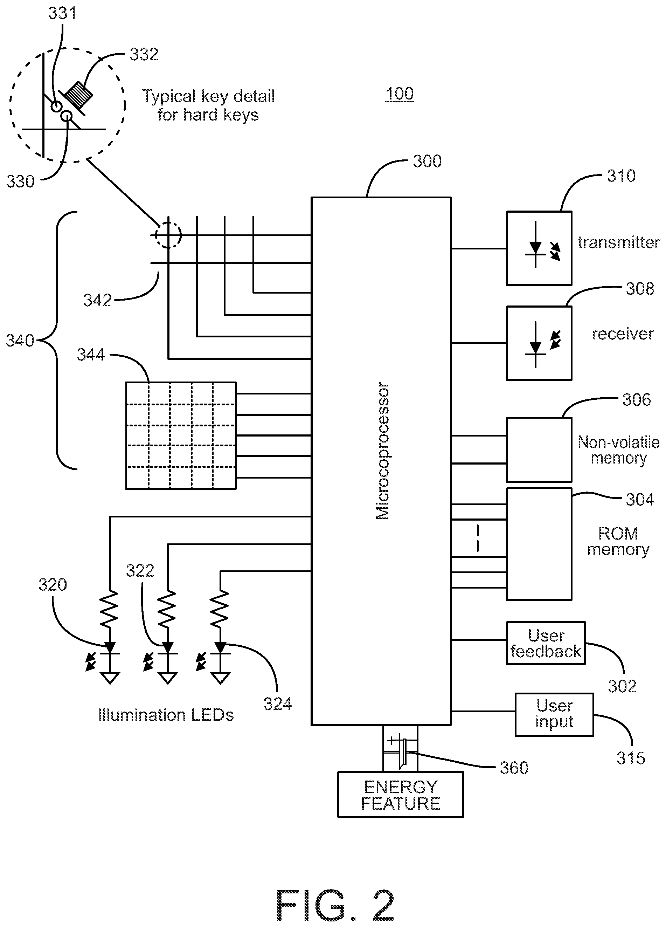

For use in commanding the functional operations of one or more appliances, the controlling devices 100 may include, as needed for a particular application, a processor 300 coupled to a ROM memory 304, a key matrix 340 (e.g., soft keys 344 such as a touch sensitive surface placed over an underlying surface on which key icons are printed or etched alone or combined with hard keys 342, a touch sensitive surface placed over a liquid crystal display (LCD) or an electroluminescent display (EL), etc.), transmission circuit(s) 310, receiver circuit(s) 308 and/or transceiver circuit(s) (e.g., IR and/or RF), a non-volatile read/write memory 306, a means 302 to provide feedback to the user (e.g., LED, display, speaker, and/or the like), a means 315 (such as a microphone, etc.) for receiving additional non-keypress input from the user, and means for providing visual and/or audio cues to the user, as illustrated in Fig. 2. The various devices may be powered by a battery power source 360, e.g., two AA batteries, as is conventional. As described further below, the battery power source 360 can alternatively or additionally include a power store, such as a capacitor, that is provided with/charged using harvested energy.

The means for providing visual and/or audio cues to the user so as to disseminate information to the user may be embodied as key illumination means, a device face illumination means, a sound or voice synthesizer circuit and/or a digital recording and playback circuit (for example to allow a user to playback sound or voice tags input via a microphone or otherwise downloaded into the controlling device). The key illumination means may be in the form of separate elements, such as LEDs 320, 322, and 324, either directly associated with a hard key matrix or used for indirect general illumination of an area such as in the case of an internally illuminated translucent display panel, i.e., a face panel that allows all or some incident light to pass completely through it, or may be integrated as part of the key matrix, for example in the case where the key matrix is implemented using a touch screen display overlaid on an LCD, EL or ink screen printed display panel. In the case where the controlling device 100 includes hard keys, an exemplary molded-in key 332 is shown as operative with key matrix circuit 330, 331.

As will be understood by those skilled in the art, the ROM memory 304 may include executable instructions that are intended to be executed by the processor 300 to control the operation of the remote control 100. In this manner, the processor 300 may be programmed to control the various electronic components within the remote control 100, e.g., to monitor/control the power supply 360, to cause the transmission of signals, control the key illumination means 320, 322, and 324, sound circuits, device face illumination means, etc. The non-volatile read/write memory 306, for example an EEPROM, battery-backed up RAM, Smart Card, memory stick, or the like, may be provided to store setup data and parameters as necessary. While the memory 304 is illustrated and described as a ROM memory, memory 304 can also be comprised of any type of readable media, such as ROM, RAM, SRAM, FLASH, EEPROM, or the like. Preferably, the memory 304 is non-volatile or battery-backed such that data is not required to be reloaded after battery changes. In addition, the memories 304 and 306 may take the form of a chip, a hard disk, a magnetic disk, and/or an optical disk.

To cause the controlling device 100 to perform an action, the controlling device 100 is adapted to be responsive to events, such as a sensed user interaction with the key matrix 340, receipt of a transmission via receiver 308, etc. In response to an event, appropriate instructions within the memory 304 may be executed. For example, when a function command key is activated on the controlling device 100, the controlling device 100 may retrieve a command code corresponding to the activated function command key from memory 304 and transmit the command code to an intended target appliance, e.g., STB 104, in a format recognizable by that appliance. It will be appreciated that the instructions within the memory 304 can be used not only to cause the transmission of command codes and/or data to the appliances, but also to perform local operations. While not limiting, local operations that may be performed by the controlling device 100 may include displaying information/data, favorite channel setup, macro key setup, function key relocation, user programming of favorite channel selections, etc. A further, local operation is the ability to "lock" function keys across device operational modes as described in U.S. Published Patent Application No. 2003/0025840. Examples of still further local operations can be found in U.S. Patent Nos. 5,481,256, 5,959,751, and 6,014,092.

For creating a correspondence between a command code and a function command key, data may be entered into the controlling device 100 that functions to identify an intended target appliance by its type and make (and sometimes model). Such data allows the controlling device 100 to transmit recognizable command codes in the format appropriate for such identified appliances. Typically, intended target appliances are identified for each operational mode of the controlling device 100. Since methods for setting up a controlling device to command the operation of specific home appliances are well-known, such methods need not be described in greater detail herein. Nevertheless, for additional information pertaining to setup procedures, the reader may turn to U.S. Patent Nos. 4,959,810, 5,614,906, and 6,225,938. It will also be appreciated that a controlling device 100 may be set up to command an appliance 102 by being taught the command codes needed to command such appliance as described in U.S. Patent No. 4,623,887. Still further, it will be understood that command codes may be pre-stored in the controlling device 100 or the controlling device 100 may be upgradeable, for example via use of receiver 308.

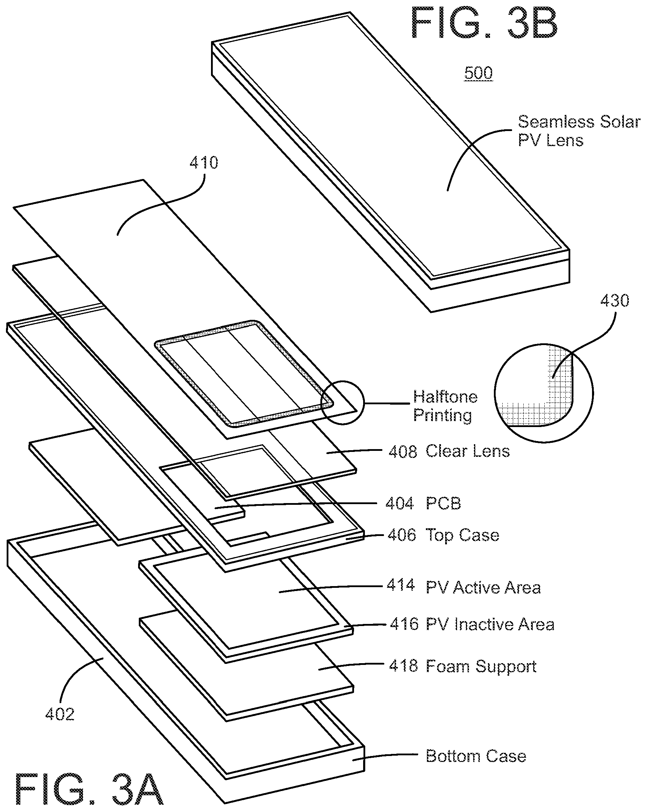

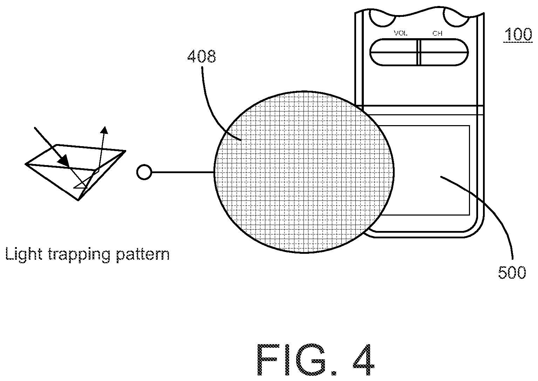

Turning to Figs. 3A and 3B, an example light-based energy harvesting feature 500 which is intended to be seamlessly incorporated into the controlling device 100 is shown. In the example, at least the electronic components necessary to collect, store, and use the light energy are preferably included on printed circuit board (PCB) 404 and the PCB 404 is preferably maintained within a housing which, in this example, comprises a housing lower section 402 that is adjoined to a housing upper section 406. The lower and/or the upper housing sections could be integral to the casing of the remote control 100 as shown in Fig. 4 or the housing components 402 could be seamlessly attached to the casing of the remote control 100 as desired. In either case, the upper housing portion 406 is intended to support a photovoltaic (PV) lens. The PV lens in this example is comprised of a clear lens 408 that is associated with a mask 410.

As further seen in Fig. 3A, the top casing portion 406 includes an opening 412, e.g., a square or rectangular opening, under which is positioned a PV active area 414 of a PV supporting substrate 416. As will be appreciated, the PV active area 414 is coupled to the energy management components of the PCB 404. While not required, a foam support 418 may be positioned under the PV substrate 416 to support the PV substrate 416 within the housing and to maintain the PV active area 414 of the PV substrate 416 in alignment with the opening 412. While not illustrated in Fig. 3A, it will be appreciated that components of the seamless light or solar lens, when installed within the controlling device 100, will be coupled to the remaining components of the remote control 100, such as the processor, as needed.

With respect to the mask 410, the mask 410 is intended to cooperate with the lens 408 such that the lens 408 and, accordingly, the entirety of the seamless solar assemblage, will blend into the controlling device casing. In other words, the mask 410 is intended to conceal or hide the fact that the controlling device 100 includes a light-based energy harvesting feature while still allowing for light to access the PV active area 414. To this end, the mask 410 may comprise a halftone dotted mask 430 printed on the top surface of the lens 408 so as to visually blur the opening 412 in the top case frame 406. The halftone dotted mask will thus function to make the energy harvesting feature look more seamless while still allowing enough light to pass therethrough to maintain good light performance. The halftone dotted mask can partially overlie the opening 414, such as by being positioned over top of the side edges of the opening 412 as illustrated in Fig. 3A, or can be positioned to completely overlie the opening 412. The portions of the lens 408 not overlying the PV active area 414 can be completely masked so as to completely blend into the overall appearance of the controlling device 100. The mask 410 can be applied using in-mold decoration (IMD).

In further examples, the mask 410 can be printed on a substrate with the substrate being placed upon the lens 408. Similarly, the mask 410 need not be provided by the use of printed ink but can be provided by use of other surface finishes such a one-way mirror, tint, etc. Accordingly, the concept is not to be limited to "printing" but can be more generally considered as being a "finishing" the is provided directly or indirectly to the surface of the lens 408 for the purpose of blending the PV area into the overall controlling device design.

As noted above, the PV assembly is desired to provide a light panel lens with special patterns and textures to maximize PV cell performance while visually disguised the PV panel under the lens. As further shown in Fig. 4, the surface patterns and textures provided to the lens 408 are selected to increase refractive light while reducing reflection, therefore maximizing energy generation. To this end, one or more of the following surface patterns are utilized: reverse pyramids varying in size, depth, and pattern (as shown in Fig. 4); reverse cones varying in size, depth, and pattern; frosted surfaces; and tinted surfaces in different colors allowing different spectrums of light through. Such a light panel will be understood to have a higher energy density that can effectively generate power under normal indoor lighting conditions.

In addition to the use of a light-based energy harvesting feature, it is also contemplated that the controlling device 100 can use the additional or alternative energy harvesting features. For example, one or more of the hard keys 332, if utilized, may be associated with a piezoelectric capture module and a power supply management module (which module may be included as a component part of the processing device 300). In this manner, when the hard key 332 is activated by a user, the piezoelectric capture module will function to convert the mechanical energy associated with the pressing movement of the key 332 into electrical energy and the resulting electrical energy will be managed, e.g., stored and used, as dictated by the instructions of which the power supply management module is comprised. A non-limiting example of such an energy harvesting key may be found CN112631444A the disclosure of which is incorporated hereby by reference in its entirety. It will also be appreciated that a piezoelectric device can be utilized to harvest energy in response to general movements of the controlling device 100 itself. Still further, it will be appreciated that RF harvesting can be used to generate power from ambient RF signals as a supplemental energy source.

While various concepts have been described in detail, it will be appreciated by those skilled in the art that various modifications and alternatives to those concepts could be developed in light of the overall teachings of the disclosure. Additionally, while the embodiments presented above are described in the context of universal remote controls (i.e. controlling devices capable of commanding the operation of multiple classes of appliances devices from multiple manufacturers) as being most broadly representative of controlling devices in general, it will be appreciated that the teachings of this disclosure may be equally well applied to other controlling devices of narrower capability without departing from the scope of the present invention. As such, the particular concepts disclosed are meant to be illustrative only and not limiting as to the scope of the invention which is to be given the full breadth of the appended claims and any equivalents thereof.

## Claims

1. A controlling device, comprising:
a housing;
a processing device (300);
a user input (340) coupled to the processing device (300);
a transmitter (310) coupled to the processing device (300) wherein the processing device (300) is configured to cause the transmitter (310) to send commands responsive to select user interactions with the user input (340); and
at least a light-based energy harvesting system (500) disposed within the housing, the light-based energy harvesting system (500) operative to supply power to at least one of the processing device (300) and the transmitter (310);
wherein the light-based energy harvesting system (500) comprises a substrate (416) having a photovoltaic, PV,
active area (414), a lens (408) disposed over the PV active area (414), and a mask (410) associated with the lens (408), the mask (410) providing a finishing to a surface of the lens (408) that functions to allow light to reach the PV active area (414) through the mask (410) while blending the light-based energy harvesting system (500) into the housing;
**characterized in that** the lens (408) comprises a plurality of reverse pyramids or cones in an area over the PV active area.

2. The controlling device as recited in claim 1, wherein the mask (410) is directly applied to the surface of the lens (408).

3. The controlling device as recited in claim 2, wherein the mask (410) comprises a half-tone pattern printed upon the surface of the lens (408).

4. The controlling device as recited in claim 3, wherein the half-tone pattern covers an entirety of the PV active area (414).

5. The controlling device as recited in claim 3, wherein the half-tone pattern covers only edge portions of the PV active area (414).

6. The controlling device as recited in claim 2, wherein the mask (410) comprises a tinting provided upon the surface of the lens (408).

7. The controlling device as recited in claim 2, wherein the mask (410) comprises a one-way mirroring provided upon the surface of the lens (408).

8. The controlling device as recited in claim 1, wherein the mask (410) is provided to a masking substrate that is overlayed upon the surface of the surface of the lens (408).

9. The controlling device as recited in claim 8, wherein the mask (410) comprises a half-tone pattern printed upon the masking substrate.

10. The controlling device as recited in claim 9, wherein the half-tone pattern covers an entirety of the PV active area (414).

11. The controlling device as recited in claim 9, wherein the half-tone pattern covers only edge portions of the PV active area (414).

12. The controlling device as recited in claim 8, wherein the mask (410) comprises a tinting provided upon the masking substrate.

13. The controlling device as recited in claim 8, wherein the mask (410) comprises a one-way mirroring provided upon the masking substrate.

## Patentansprüche

1. Steuerungsvorrichtung, umfassend:
ein Gehäuse;
eine Verarbeitungsvorrichtung (300);
eine Benutzereingabe (340), die mit der Verarbeitungsvorrichtung (300) gekoppelt ist;
einen Sender (310), der mit der Verarbeitungsvorrichtung (300) gekoppelt ist, wobei die Verarbeitungsvorrichtung (300) so konfiguriert ist, dass sie den Sender (310) veranlasst, Befehle als Reaktion auf ausgewählte Benutzerinteraktionen mit der Benutzereingabe (340) zu senden; und
mindestens ein lichtbasiertes Energiegewinnungssystem (500), das innerhalb des Gehäuses angeordnet ist, wobei das lichtbasierte Energiegewinnungssystem (500) dazu dient, mindestens eines der Verarbeitungsvorrichtung (300) und des Senders (310) mit Strom zu versorgen;
wobei das lichtbasierte Energiegewinnungssystem (500) ein Substrat (416) umfasst, das einen photovoltaisch, PV, aktiven Bereich (414) aufweist, sowie eine über dem PV aktiven Bereich (414) angeordnete Linse (408) und eine der Linse (408) zugeordnete Maske (410), wobei die Maske (410) eine Oberflächenbeschichtung der Linse (408) bildet, die dazu dient, Licht durch die Maske (410) zum PV aktiven Bereich (414) gelangen zu lassen, während das lichtbasierte Energiegewinnungssystem (500) in das Gehäuse eingefügt wird;
**dadurch gekennzeichnet, dass** die Linse (408) eine Vielzahl von umgekehrten Pyramiden oder Kegeln in einem Bereich über dem PV aktiven Bereich umfasst.

2. Steuerungsvorrichtung nach Anspruch 1, wobei die Maske (410) direkt auf die Oberfläche der Linse (408) aufgebracht ist.

3. Steuerungsvorrichtung nach Anspruch 2, wobei die Maske (410) ein auf die Oberfläche der Linse (408) aufgedrucktes Halbtonmuster umfasst.

4. Steuerungsvorrichtung nach Anspruch 3, wobei das Halbtonmuster den gesamten PV aktiven Bereich (414) bedeckt.

5. Steuerungsvorrichtung nach Anspruch 3, wobei das Halbtonmuster nur die Randabschnitte des PV aktiven Bereichs (414) bedeckt.

6. Steuerungsvorrichtung nach Anspruch 2, wobei die Maske (410) eine Tönung umfasst, die auf der Oberfläche der Linse (408) vorgesehen ist.

7. Steuerungsvorrichtung nach Anspruch 2, wobei die Maske (410) eine Einwegverspiegelung umfasst, die auf der Oberfläche der Linse (408) vorgesehen ist.

8. Steuerungsvorrichtung nach Anspruch 1, wobei die Maske (410) auf einem Maskierungssubstrat vorgesehen ist, das auf der Oberfläche der Linse (408) aufliegt.

9. Steuerungsvorrichtung nach Anspruch 8, wobei die Maske (410) ein auf das Maskierungssubstrat aufgedrucktes Halbtonmuster umfasst.

10. Steuerungsvorrichtung nach Anspruch 9, wobei das Halbtonmuster den gesamten PV aktiven Bereich (414) bedeckt.

11. Steuerungsvorrichtung nach Anspruch 9, wobei das Halbtonmuster nur die Randabschnitte des PV aktiven Bereichs (414) bedeckt.

12. Steuerungsvorrichtung nach Anspruch 8, wobei die Maske (410) eine auf dem Maskierungssubstrat aufgebrachte Tönung umfasst.

13. Steuerungsvorrichtung nach Anspruch 8, wobei die Maske (410) eine auf dem Maskierungssubstrat aufgebrachte Einwegverspiegelung umfasst.

## Revendications

1. Dispositif de commande, comprenant :
un boîtier ;
un dispositif de traitement (300) ;
un organe d'entrée utilisateur (340), relié au dispositif de traitement (300) ;
un émetteur (310) relié au dispositif de traitement (300), dans lequel le dispositif de traitement (300) est configuré pour amener l'émetteur (310) à envoyer des commandes en réponse à des interactions de l'utilisateur avec l'organe d'entrée utilisateur (340) ; et
au moins un système (500) de collecte d'énergie basé sur la lumière, disposé à l'intérieur du boîtier, le système (500) de collecte d'énergie basé sur la lumière étant apte à alimenter en énergie au moins un parmi le dispositif de traitement (300) et l'émetteur (310) ;
dans lequel le système (500) de collecte d'énergie basé sur la lumière comprend un substrat (416) ayant une zone active photovoltaïque, PV, (414), une lentille (408) disposée au-dessus de la zone active PV (414), et un masque (410) associé à la lentille (408), le masque (410) fournissant une finition à une surface de la lentille (408) qui fonctionne de manière à permettre à la lumière d'atteindre la zone active PV (414) à travers le masque (410) tout en intégrant le système (500) de collecte d'énergie basé sur la lumière dans le boîtier ;
**caractérisé en ce que** la lentille (408) comprend une pluralité de pyramides inversées ou de cônes inversés dans une zone au-dessus de la zone active PV.

2. Dispositif de commande tel que défini dans la revendication 1, dans lequel le masque (410) est directement appliqué sur la surface de la lentille (408).

3. Dispositif de commande tel que défini dans la revendication 2, dans lequel le masque (410) comprend un motif en demi-teintes imprimé sur la surface de la lentille (408).

4. Dispositif de commande tel que défini dans la revendication 3, dans lequel le motif en demi-teintes couvre une totalité de la zone active PV (414).

5. Dispositif de commande tel que défini dans la revendication 3, dans lequel le motif en demi-teintes couvre seulement des portions de bordure de la zone active PV (414).

6. Dispositif de commande tel que défini dans la revendication 2, dans lequel le masque (410) comprend un teintage appliqué sur la surface de la lentille (408).

7. Dispositif de commande tel que défini dans la revendication 2, dans lequel le masque (410) comprend un effet de miroir sans tain appliqué sur la surface de la lentille (408).

8. Dispositif de commande tel que défini dans la revendication 1, dans lequel le masque (410) est prévu sur un substrat de masquage qui est superposé sur la surface de la lentille (408).

9. Dispositif de commande tel que défini dans la revendication 8, dans lequel le masque (410) comprend un motif en demi-teintes imprimé sur le substrat de masquage.

10. Dispositif de commande tel que défini dans la revendication 9, dans lequel le motif en demi-teintes couvre une totalité de la zone active PV (414).

11. Dispositif de commande tel que défini dans la revendication 9, dans lequel le motif en demi-teintes couvre seulement des portions de bordure de la zone active PV (414).

12. Dispositif de commande tel que défini dans la revendication 8, dans lequel le masque (410) comprend un teintage appliqué sur le substrat de masquage.

13. Dispositif de commande tel que défini dans la revendication 8, dans lequel le masque (410) comprend un miroir sans tain placé sur le substrat de masquage.
